# EUROPEAN PATENT APPLICATION

(11) **EP 2 840 434 A1**
(43) Date of publication of application: **25.02.2015**
(21) Application number: 13190568.9
(22) Date of filing: 29.10.2013
(51) Int. Cl.: G02F 1/1333

(54) **Display device**

(30) Priority: 19.08.2013 TW 102129626
(71) Applicant: InnoLux Corporation, Chu-Nan, Miao-Li 350 (TW)
(72) Inventor: Wu, Hsin-Tien, 350 Chu-Nan, Miao-Li County (TW); Tsai, Kun-Sheng, 350 Chu-Nan, Miao-Li County (TW); Wang, Chao-Hsiang, 350 Chu-Nan, Miao-Li County (TW)
(74) Representative: 2K Patentanwälte Blasberg Kewitz & Reichel

(57) **Abstract**

A display device (100) is disclosed, which includes a display panel (130), a frame (140), and a spacer unit (150). The frame includes a number of sub-frames (141, 143). At least one boundary region is formed between each two of the neighboring sub-frames. The spacer unit (150) is positioned between the display panel and the frame and partially overlaps with the at least one boundary region, wherein the spacer unit (150) is across two adjacent edges of each two of the neighboring sub-frames and contacts with two surfaces of each two of the neighboring sub-frames.

## Description

### CROSS REFERENCE TO RELATED APPLICATIONS

This Application claims priority of Taiwan Patent Application No.102129626, filed on Aug. 19, 2013, the entirety of which is incorporated by reference herein.

### BACKGROUND OF THE DISCLOSURE

### FIELD OF THE DISCLOSURE

The present disclosure relates to an electronic device and components thereof, and in particular to a display device and a frame thereof.

### DESCRIPTION OF THE RELATED ART

In recent years, with great advances in fabrication techniques, portable electronic devices and flat panel displays have been vigorously developed. As flat display devices have advantages such as light weight, thin thickness, small size, and low power consumption, they have become increasingly popular and are widely applied to various electronic devices.

Due to the fact that the frames of conventional flat displays are integrally formed as a single piece, molds for fabricating the frames with various dimensions have to be redeveloped, thus increasing the manufacturing cost. In addition, the development of a larger frame structure requires a large-scale apparatus, resulting in increasing the equipment cost.

### BRIEF SUMMARY OF THE DISCLOSURE

In this regard, the present disclosure is desired to provide a display device. The display device includes a number of components, and the components are assembled by suitable means so as to overcome the drawbacks of the prior art.

According to some embodiments of the disclosure, the display device includes a display panel, a frame, and a spacer unit. The frame includes a number of sub-frames. The spacer unit is positioned between the display panel and the frame. The spacer unit overlaps with at least one of the boundary regions that are formed between two of the neighboring sub-frames. Specifically, the frame includes a first sub-frame and a second sub-frame. The first sub-frame has a first edge and a first surface. The second sub-frame has a second edge and a first surface. The first edge is adjacent to the second edge, and the first surface and the second surface are faced to the display panel. The spacer unit is across the first edge and the second edge, and the spacer unit is in contact with the first surface and the second surface.

In accordance with some embodiments, the display panel includes a first substrate, a second substrate, a display element unit, and a sealing unit. The display element unit is positioned between the first substrate and the second substrate. The sealing unit is positioned at the outer side of the display element unit, and the sealing unit partially overlaps with the projection of the spacer unit.

In accordance with some embodiments, the display panel further includes an optical film. The optical film is positioned between the frame and the first substrate, and the optical film partially overlaps with the spacer unit.

In accordance with some embodiments, each of the sub-frames has an outer edge and an inner edge parallel with the outer edge. The width of the inner edge is smaller than the width of the outer edge. The distance between the spacer unit and the inner edge is less than or equal to the distance between the spacer unit and the outer edge. Specifically, the first sub-frame has a third edge and a fourth edge, and the first edge is positioned between the third edge and the fourth edge. The width of the third edge is smaller than the width of the fourth edge, and the distance between the spacer unit and the third edge is less than or equal to the distance between the spacer unit and the fourth edge.

In accordance with some embodiments, the display panel includes a connecting unit. The connecting unit connects the first edge to the second edge, and the sub-frames are connected with each other by the connecting unit so as to form the frame. Specifically, the connecting unit connects the first edge to the second edge and connected the first surface to the second surface.

In accordance with some embodiments, the connecting unit is a connecting structure formed by a method including welding, screwing, gluing, interlocking, clamping, or pressure fitting.

In accordance with some embodiments, the spacer unit includes a first spacer structure and a second spacer structure. The first spacer structure is positioned at the first surface, and the second spacer structure is positioned at the second surface, wherein the first spacer structure partially overlaps with the second spacer structure.

In accordance with some embodiments, the display device further includes a housing. The display panel is positioned between the frame and the housing, and the frame and the housing are connected with each other by a fastening portion.

### BRIEF DESCRIPTION OF THE DRAWINGS

The present disclosure is more fully understood by reading the subsequent detailed description and examples with references made to the accompanying drawings.

FIG. 1 shows a schematic cross-sectional view of a display device, in accordance with some embodiments.

FIG. 2A shows a schematic view of a frame before lateral wall panels of the frame being bent relative to front wall panels, in accordance with some embodiments.

FIG. 2B shows a schematic view of a frame, in accordance with some embodiments, wherein lateral wall panels of the frame are perpendicular to front wall panels.

FIG. 3 shows a schematic view of a frame and a spacer unit, in accordance with some embodiments.

FIG. 4 shows a partial magnified view of a display device, in accordance with some embodiments.

FIG. 5 shows a cross-sectional view taken along line A-A of FIG. 3.

FIG. 6 shows a schematic view of a frame and a spacer unit, in accordance with some embodiments.

FIG. 7 shows a cross-sectional view taken along line B-B of FIG. 6.

FIG. 8 shows a schematic view of a frame and a spacer unit, in accordance with some embodiments.

FIG. 9 shows a schematic view of a frame and a spacer unit, in accordance with some embodiments.

### DESCRIPTION OF THE DISCLOSURE

The following description is of the best-contemplated mode of carrying out the disclosure. This description is made for the purpose of illustrating the general principles of the disclosure and should not be taken in a limiting sense. The scope of the disclosure is best determined by reference to the appended claims.

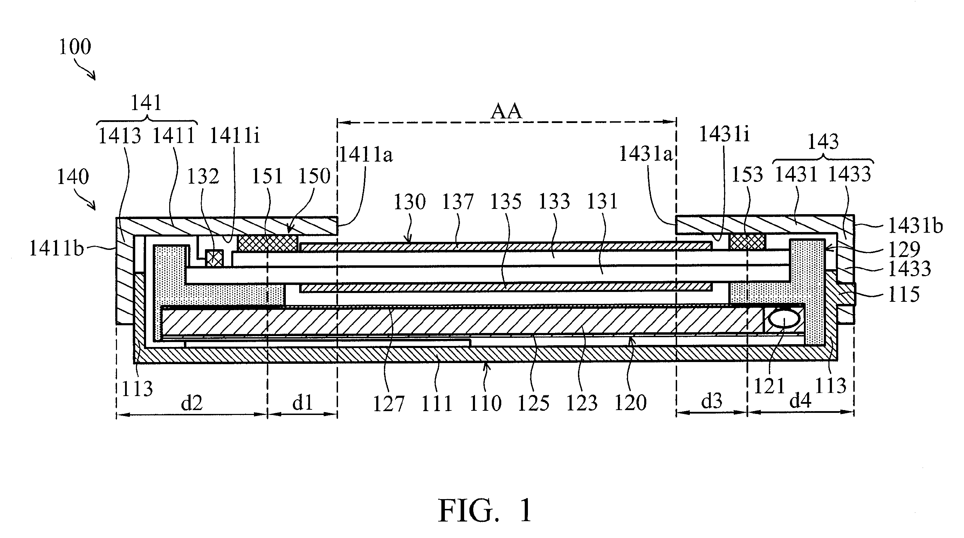

Referring to FIG. 1, a display device 100 (such as a liquid crystal display device) includes a rear bezel 110, a backlight unit 120, a display panel 130, a frame 140, and a spacer unit 150, in accordance with some embodiments.

The rear bezel 110 includes a bottom plate 111 and four side plates 113 perpendicular with the bottom plate 111. The backlight module 120 includes a number of light sources 121 (only one light source 121 is shown in FIG. 1), a light guide plate 123, a reflective sheet 125, a diffusion sheet 127, and a housing 129. The light sources 121 face to the light-receiving surface of the light guide plate 123. The diffusion sheet 127 is arranged on the light-emitting surface of the light guide plate 123. The reflective sheet 125 is arranged on a bottom surface of the light guide plate 123. The light sources 121, the light guide plate 123, the reflective sheet 125, and the diffusion sheet 127 are received in an accommodation space (not indicated in FIG. 1) formed by the rear bezel 110 and the housing 129.

Adjacent to the light emitting-surface of the light guide plate 123, the display panel 130 is positioned on the housing 129. The display panel 130 includes a first substrate 131, a second substrate 133, a display element unit 138, a sealing unit 139, an optical film 135 connected to the light-receiving side of the first substrate 131, and an optical film 137 connected to the light emitting side of the second substrate 133. The display element unit 138 may include a number of structures such as thin-film transistors (TFT), trace lines, electrodes, capacitors, diodes, liquid crystal layer, OLED layer, and color filters, etc.. The sealing unit 139 may be a sealant. In some embodiments, each of the optical films 135 and 137 is a polarization sheet, the optical films 135 and 137 are configured to polarize light emitted from the backlight module 120 so as to enable the display device 100 to display the image. For the purpose of illustration, in the following descriptions, the optical film 135 refers to a lower polarization sheet, and the optical film 137 refers to an upper polarization sheet.

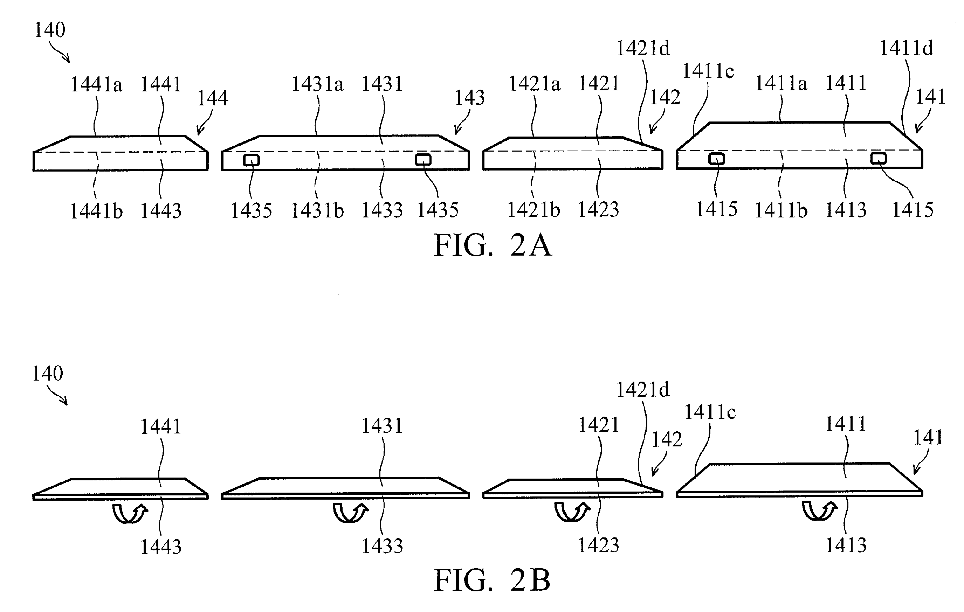

Referring to FIG. 2A, the frame 140 includes four sub-frames, such as a first sub-frame 141, a second sub-frame 142, a third sub-frame 143, and a fourth sub-frame 144. The first sub-frame 141 includes a front wall panel 1411 and a lateral wall panel 1413. The second sub-frame 142 includes a front wall panel 1421 and a lateral wall panel 1423. The third sub-frame 143 includes a front wall panel 1431 and a lateral wall panel 1433. The fourth sub-frame 144 includes a front wall panel 1441 and a lateral wall panel 1443.

The front wall panel 1421 of the first sub-frame 141 is constructed in a trapezoidal shape, and the front wall panel 1421 has a first edge 1411c, a second edge 1411d, a third edge 1411a, and a fourth edge 1411b. The first edge 1411c and the second edge 1411d are two lateral sides of the first sub-frame 141. The third edge 1411a (inner edge) is an upper base of the first sub-frame 141, and the fourth edge 1411b (outer edge) is a lower base of the first sub-frame 141. In the embodiment shown in FIGs. 2A and 2B, the first, second, third, and fourth sub-frames 141, 142, 143, and 144 have similar structures; thus, the structural features of the second, third, and fourth sub-frames 142, 143, and 144 are omitted for brevity. In some embodiments, each of the first, second, third, and fourth sub-frames 141, 142, 143, and 144 is an individual and independent element, but the disclosure should not be limited thereto. In some other embodiments, the first sub-frame 141 and the second sub-frame 142 are fabricated as a single piece in an L-shape, and the third sub-frame 143 and the fourth sub-frame 144 are fabricated as a single piece in an L-shape. The two pieces are connected so as to form an integral frame 140. In some other embodiments, the first sub-frame 141, the second sub-frame 142, the third sub-frame 143, and the fourth sub-frame 144 are fabricated as a single piece in a strip shape, and the sub-frames are bent to form an integral frame 140.

The lateral wall panels 1413, 1423, 1433, and 1443 are arranged in order (or selectively connected as a single piece), and the lateral wall panels 1413, 1423, 1433, and 1443 are respectively connected to the edges 1411b, 1421b, 1431b, and 1441b of the front wall panels 1411, 1421, 1431, and 1441. As shown in FIG. 2A, a number of through holes 1415 and 1435 are formed on the lateral wall panels 1413 and 1433. Engaging portions 115 formed on the side wall plate 113 of the rear bezel 110 are engaged in the through holes 1415 and 1435, so as to assembly the frame 140 and the rear bezel 110.

The frame 140 is fabricated by a method described below, in accordance with some embodiments. First, the lateral wall panels 1413, 1423, 1433, 1443 are bent toward a direction (as indicated by the arrows shown in FIG. 2B) along the edges 1411b, 1421b, 1431b, and 1441b, such that the lateral wall panel 1413, 1423, 1433, and 1443 are perpendicular to the front wall panels 1411, 1421, 1431, and 1441. Afterward, the first edges of each of the four lateral wall panels 1413, 1423, 1433, and 1443 are connected to the second edges of each of the neighboring lateral wall panels 1413, 1423, 1433, and 1443 by suitable means. For example, in some embodiments, the front wall panel 1411 of the first sub-frame 141 is connected to the second edge 1421d of the front wall panel 1421 of the second sub-frame 142 via the first edge 1411c, and so on. Additionally, the lateral wall panel 1413 of the first sub-frame 141 is connected to the lateral wall panel 1443 of the fourth sub-frame 144 through similar means.

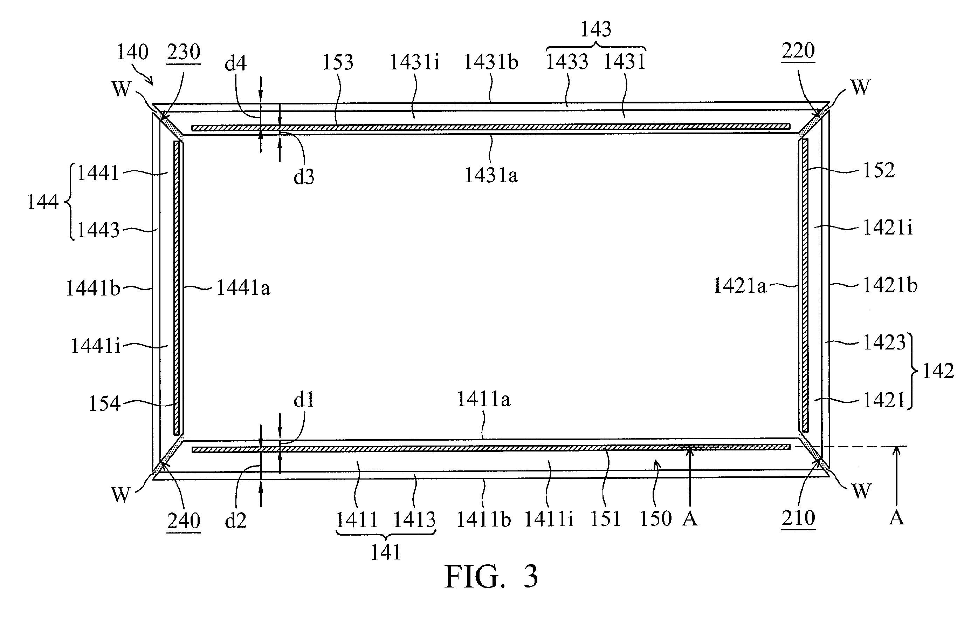

In some embodiments, the first, second, third, and fourth sub-frames 141, 142, 143, and 144 are laser welded by the use of the CO2 laser. During the laser welding process, the surfaces of the sub-frames to be connected are melted so as to form one or more than one connecting unit W (at the front wall panels and the lateral wall panels), as shown in FIG. 3. In some other embodiments, the first, second, third, and fourth sub-frames 141, 142, 143, and 144 are laser welded by the use of a YAG (neodymium-doped yttrium aluminum garnet; Nd:Y3Al5O12) laser, so as to form one or more than one connecting unit W. In some other embodiments, the means to connect the sub-frames includes the use of a connecting unit formed by any of the methods including screwing, gluing, interlocking, clamping, or pressure fitting. In some embodiments, since the lateral wall panels are formed as a single piece (some of the lateral wall panels are connected by a bending structure), the number of connecting units W used for connecting the lateral wall panels is less than or equal to the number of connecting units W used for connecting the front wall panels.

Referring to FIG. 3, the spacer unit 150 includes a number of spacer members, such as a first spacer member 151, a second spacer member 152, a third spacer member 153, and a fourth spacer member 154. Each of the first, second, third, and fourth spacer members 151, 152, 153, and 154 is arranged on the surfaces 1411i, 1421i, 1431i, and 1441i of the first, second, third, and fourth sub-frames 141, 142, 143, and 144, wherein the surfaces 1411i, 1421i, 1431i, and 1441i are adjacent to the display panel 130 (FIG. 1). With the spacer unit 150 positioned between the display pane 130 and the frame 140, damage to the display panel 130 due to contact with the frame 140 can be prevented.

It is noted that, as shown in FIG. 3, in some embodiments, the length of each of the first, second, third, and fourth spacer members 151, 152, 153, and 154 is not greater than the length of the corresponding front wall panels 1411, 1421, 1431, and 1441. Moreover, each of the first, second, third, and fourth spacer members 151, 152, 153, and 154 is arranged on one of the corresponding front wall panels 1411, 1421, 1431, and 1441. Each of the first, second, third, and fourth spacer members 151, 152, 153, and 154 is not across boundary regions 210, 220, 230, and 240 between each of the two neighboring front wall panels 1411, 1421, 1431, and 1441.

On the other hand, in some embodiments, each of the first, second, third, and fourth spacer members 151, 152, 153, and 154 is arranged on the corresponding front wall panels 1411, 1421, 1431, and 1441 in a manner that is close to the third edges 1411a, 1421a, 1431a, and 1441a. For example, the first spacer member 151 arranged on the front wall panel 1411 and the third edge 1411a are spaced by the distance d1, and the first spacer member 151 and the fourth edge 1411b are spaced by the distance d2, the distance d1 is less than the distance d2. For another example, the third spacer member 153 arranged on the front wall panel 1431 and the third edge 1431a are spaced by the distance d3, and the third spacer member 153 and the fourth edge 1431b are spaced by the distance d4, the distance d3 is less than the distance d4. However, the disclosure should not be limited to the embodiments. In some other embodiments, each of the first, second, third, and fourth spacer members 151, 152, 153, and 154 and the corresponding third edges 1411a, 1421a, 1431a, and 1441a are spaced by the distance that is equal to the distance between each of the first, second, third, and fourth spacer members 151, 152, 153, and 154 and the corresponding fourth edges 1411b, 1421b, 1431b, and 1441b.

It is noted that, referring to FIG. 1 again, the display panel 130 includes a number of circuit components 132 (such as the IC circuit signal connected with the trace lines of the display panel). The circuit components 132 are positioned on a surface of the first substrate 131 facing the first sub-frame 141. In order to prevent an overlap between the first spacer member 151 and the circuit components 132 from occurring, the distance d2 between the first spacer member 151 and the fourth edge 1411b is greater than the distance d4 between the third spacer member 153 and the fourth edge 1431b. Additionally, the distance d2 between the first spacer member 151 and the fourth edge 1411b is greater than the distance (not indicated in FIG. 1) between the second spacer member 152 and the fourth edge 1421b and is greater than the distance (not indicated in FIG. 1) between the second spacer member 154 and the fourth edge 1441b.

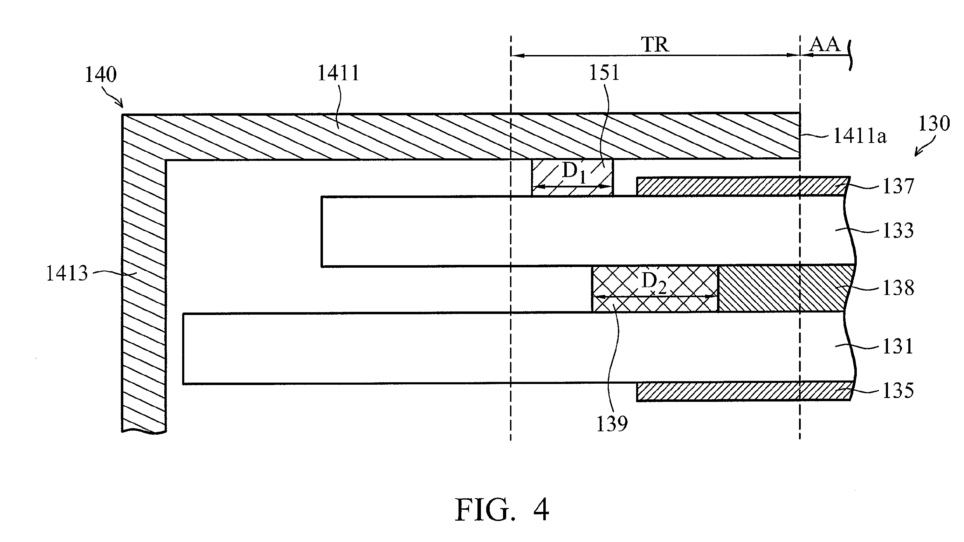

In some embodiments, the spacer unit 150 is positioned within a particular tolerance range TR, such that the stress from the spacer unit 150 is absorbed by the sealing member 130, and the stress applied on the display panel 130 from the spacer unit 150 may not cause damage to the display panel 130. In some embodiments, the width of the tolerance range TR is smaller than or equal to the sum of two times of the width D₁ of the first spacer member 151 plus the width D₂ of the sealing member 139. Namely, the tolerance range TR satisfies the relationship D_{TR}=2D₁+D₂. For example, as shown in FIG. 4, which shows a partial magnified view of a display device 100, the first spacer member 151 overlaps with the sealing member 139 positioned at the outer side of the display element unit 138. That is, an orthographic projection of the first spacer member 151 on the first substrate 131 overlaps with an orthographic projection of the sealing member 139 on the first substrate 131. In some other embodiments, the spacer unit 150 also overlaps with a portion of the upper polarizer sheet 137, or the spacer unit 150 is completely positioned on the upper polarizer sheet 137 while the orthographic projections of the first spacer member 151 and the sealing member 139 on the first substrate 131 overlap with each other. In some other embodiments, the spacer unit 150 is positioned within a tolerance range TR between an inner side of the sealing member 139 and an active area AA of the display panel 130 while the orthographic projections of the first spacer member 151 and the sealing member 139 on the first substrate 131 overlap with each other.

In some embodiments, the active area AA of the display panel 130 is an area of the display panel 130 where display pixels formed by switch elements and display elements are positioned. While the active area AA of display panel 130 shown in FIG. 4 is an area located at an inner side of the inner edges (first edge 1411a) of the frame 140, i.e. the side of the inner edges that is close to the substantial center of the display panel 130, but the disclosure should not be limited thereto. Persons skilled in the art will understand that the active area AA may also include an area of the display panel 130 that is covered by the frame 140.

In some embodiments, as shown in FIG. 3, each of the first, second, third, and fourth spacer members 151, 152, 153, and 154 is not across boundary regions 210, 220, 230, and 240 between each of the two neighboring front wall panels 1411, 1421, 1431, and 1441. Each of the two neighboring front wall panels 1411, 1421, 1431, and 1441 are merely connected by the connecting unit W. Therefore, a relative displacement of each of the two neighboring front wall panels 1411, 1421, 1431, and 1441 may occur as an external thrust force is applied to the frame 140. Moreover, foreign particles and dust may enter the display device 100 through the boundary regions 210, 220, 230, and 240 between each of the two neighboring front wall panels 1411, 1421, 1431, and 1441and may cause a decrease in the sealing property of the display device 100. Therefore, the optical effect of the display device 100 is degraded, and the life span of the components thereof is diminished.

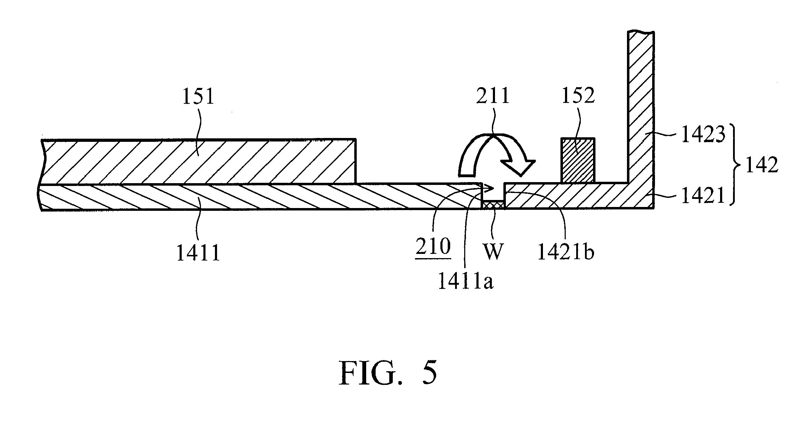

For example, as shown in FIG. 5, a displacement of the two neighboring front wall panels 1411, 1421 occurring at the boundary region 210 may cause a separation of the two neighboring front wall panels 1411, 1421. In addition, foreign particles and dust entering the display device 100 through the boundary region 210 between the two neighboring front wall panels 1411, 1421 may cause damage to the display device 100.

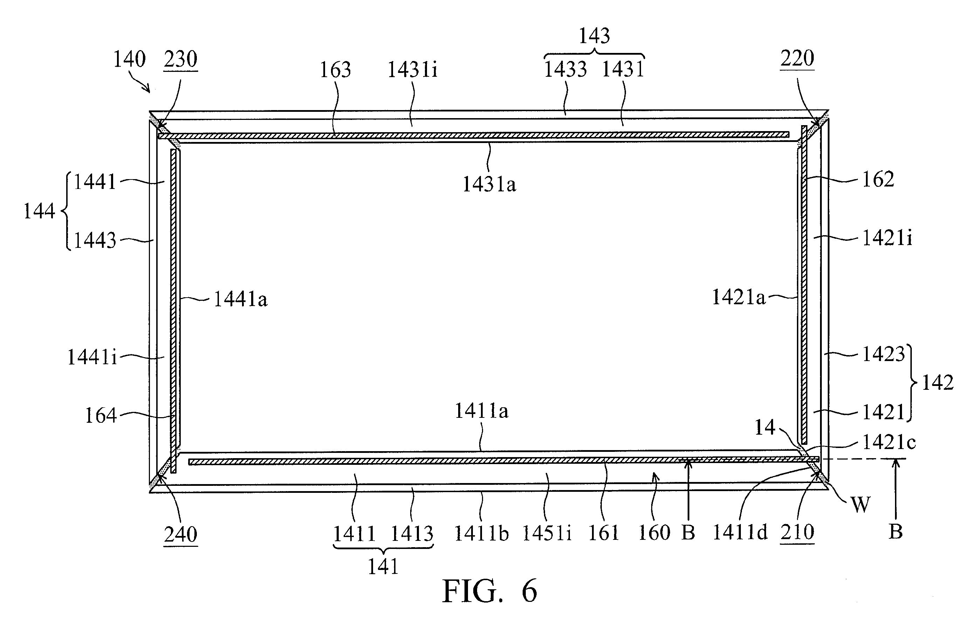

The other embodiments are provided based on the aforesaid observation results. Referring to FIG. 6, which shows a schematic view of the frame 140 and a spacer unit 160, in accordance with some embodiments. In the embodiment of FIG. 6, the spacer unit 160 replaces the spacer unit 150 shown in the embodiment of FIG. 3. The spacer unit 160 includes a number of spacer members, such as a first spacer member 161, a second spacer member 162, a third spacer member 163, and a fourth spacer member 164. Each of the first, second, third, and fourth spacer members 161, 162, 163, and 164 is arranged on the surfaces 1411i, 1421i, 1431i, and 1441i of the first, second, third, and fourth sub-frames 141, 142, 143, and 144, wherein the surfaces 1411i, 1421i, 1431i, and 1441i are adjacent to the display panel 130 (FIG. 1).

In some embodiments, the length of each of the first, second, third, and fourth spacer members 161, 162, 163, and 164 is greater than the length of the corresponding front wall panels 1411, 1421, 1431, and 1441. In addition, each of the first, second, third, and fourth spacer members 161, 162, 163, and 164 partially overlaps with at least one of the boundary regions 210, 220, 230, and 240 between each of the two neighboring front wall panels 1411, 1421, 1431, and 1441.

For example, the first spacer member 161 partially overlaps with the boundary region 210. The first spacer member 161 is across the second edge 1411d of the front wall panel 1411 and the first edge 1421c of the front wall panel 1421, and the first spacer member 161 is in contact with the surface 1411i of the front wall panel 1411 and the surface 1421i of the front wall panel 1421. In some other embodiments, two ends of one single spacer member partially overlap with two boundary regions. That is, the one single spacer is in contact with three front wall panels. In some other non-illustrated embodiments, some spacer members do not overlap with a boundary region, and some spacer members partially overlap with one boundary region or partially overlap with two boundary regions at the same time.

In some embodiments, similar to the first, second, third, and fourth spacer members 151, 152, 153, and 154, each of the first, second, third, and fourth spacer members 161, 162, 163, and 164 of the spacer unit 160 is arranged on the corresponding front wall panels 1411, 1421, 1431, and 1441 in a manner that is close to the third edges 1411a, 1421a, 1431a, and 1441a. In addition, each of the first, second, third, and fourth spacer members 161, 162, 163, and 164 is positioned between the display panel 130 and the frame 140 in a manner that is within the particular tolerance range TR, as shown in FIG. 4.

Through the arrangement mentioned above, the possibility that the relative displacement of each of the two neighboring front wall panels 1411, 1421, 1431, and 1441 is sufficiently reduced. Also, the sealing property of the display device is enhanced since foreign particles and dust can be kept out of the display device by the first, second, third, and fourth spacer members 161, 162, 163, and 164.

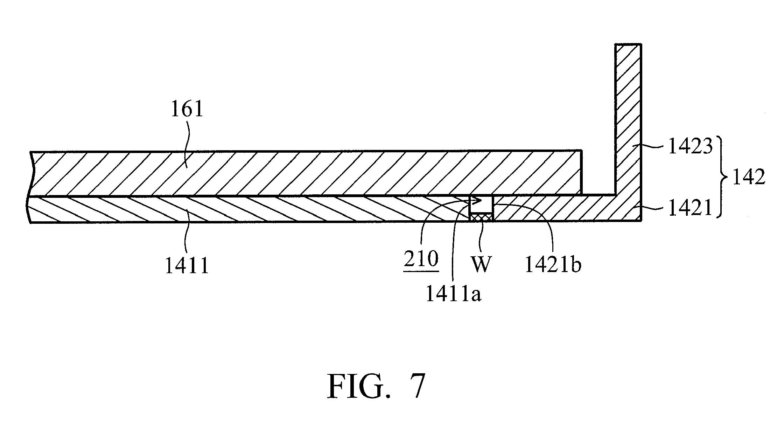

For example, as shown in FIG. 7, because the deformation of the first spacer member 161 is constrained by the surface of the display panel 130, the front wall panels 1411, 1421, supported by the first spacer member 161, do not tend to move relative each other as an external thrust force is applied thereon. Additionally, blocked by the first spacer members 161, the foreign particles and dust cannot readily pass through the boundary region 210 between the two neighboring front wall panels 1411, 1421.

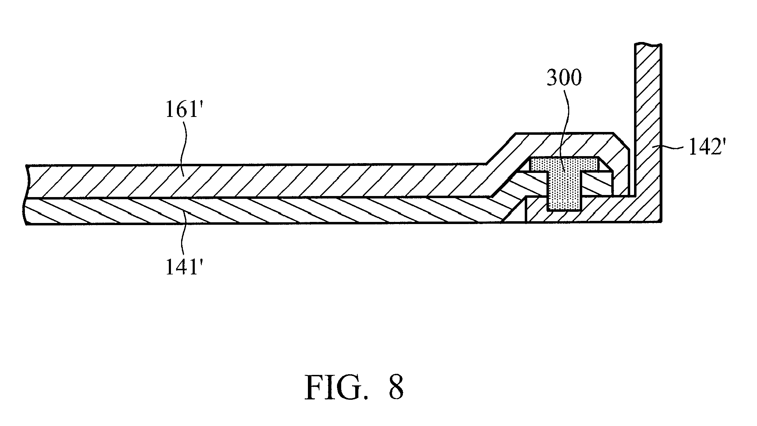

In some embodiments, each of the two neighboring front wall panels is connected by a connecting unit. For example, referring to FIG. 8, two neighboring front wall panels 141' and 142' are connected by a connecting unit 300, wherein a portion of the front wall panel 142' is overlapped by the front wall panel 141', and a connecting unit 300 (such as screw) is connected between the front wall panels 141' and 142'. In some embodiments, the connecting unit 300 is partially overlapped by the first spacer member 161', such that the display panel (FIG. 1) can be prevented from being damaged due to direct contact with the connecting unit 300.

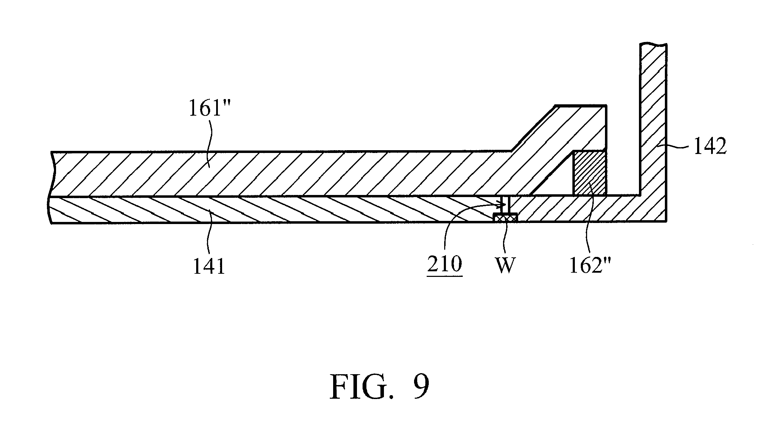

In some other embodiments, two spacer members respectively positioned on two neighboring front wall panels are partially overlapped by each other. For example, referring to FIG. 9, in some embodiments, the boundary region 210 between the neighboring front wall panels 141 and 142 is partially overlapped by a first spacer member 161 " and a second spacer member 162", and the first spacer member 161" and the second spacer member 162" are partially overlapped by each other.

The disclosure provides a frame constructed by multiple sub-frames, the frame overcomes drawbacks and limitations of conventional frame structure which is integrally formed as one piece. Additionally, a spacer unit positioned between a display panel and the frame protects the display panel from being damaged and enhances the structural strength of the frame.

While the disclosure has been described by way of example and in terms of preferred embodiment, it is to be understood that the disclosure is not limited thereto. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A display device (100), comprising:
a display panel (130);
a frame (140), comprising a first sub-frame and a second sub-frame, wherein the first sub-frame has a first edge and the second sub-frame has a second edge which is adjacent to the first edge; and
a spacer unit (150), positioned between the display panel and the frame;
wherein the spacer unit across the first edge and the second edge.

2. The display device as claimed in claim 1, wherein the display panel comprises a first substrate (131), a second substrate (133), a display element unit (138), and a sealing unit (139), wherein the display element unit is positioned between the first substrate and the second substrate, and the sealing unit is positioned at the outer side of the display element unit.

3. The display device as claimed in claim 2, wherein the sealing unit partially overlaps with the projection of the spacer unit.

4. The display device as claimed in claim 2, wherein the display panel further comprises an optical film (137) positioned between the frame and the first substrate, and the optical film partially overlaps with the spacer unit.

5. The display device as claimed in claim 2, wherein the first sub-frame (141) has a third edge and a fourth edge, and the first edge is positioned between the third edge and the fourth edge, and the width of the third edge is smaller than the width of the fourth edge, wherein the distance between the spacer unit and the third edge is smaller than or equal to the distance between the spacer unit and the fourth edge.

6. The display device as claimed in one of the preceding claims, wherein the display panel (130) further comprises a connecting unit (W) connecting the first edge to the second edge, and the plurality of sub-frames is connected by the connecting unit to form the frame.

7. The display device as claimed in claim 6, wherein the connecting unit (W) is a connecting structure formed by a method including welding, screwing, gluing, interlocking, clamping, or pressure fitting.

8. The display device as claimed in one of the preceding claims, wherein the spacer unit (150) comprises a first spacer structure and a second spacer structure, and the first spacer structure partially overlaps with the second spacer structure.

9. The display device as claimed in one of the preceding claims, further comprising a housing (129), wherein the display panel is positioned between the frame and the housing, and the frame and the housing are connected by a fastening portion.

## Amended claims

### Amended claims in accordance with Rule 137(2) EPC.

1. A display device, comprising:
a display panel (130);
a frame (140), comprising a first sub-frame (141) and a second sub-frame (142), wherein the first sub-frame (141) has a first edge (1411d) and the second sub-frame (142) has a second edge (1421c) which is adjacent to the first edge (1411d); and
a spacer unit (160), positioned between the display panel (130) and the frame (140);
wherein the spacer unit (160) is across the first edge (1411d) and the second edge (1421c).

2. The display device as claimed in claim 1, wherein the display panel (130) comprises a first substrate (131), a second substrate (133), a display element unit (138), and a sealing unit (139), wherein the display element unit (138) is positioned between the first substrate (131) and the second substrate (133), and the sealing unit (139) is a sealant which is positioned at the outer side of the display element unit (138).

3. The display device as claimed in claim 2, wherein the sealing unit (139) partially overlaps with the projection of the spacer unit (160).

4. The display device as claimed in claim 2, wherein the display panel (130) further comprises an optical film (137) positioned between the frame (140) and the first substrate (131), and the optical film (137) partially overlaps with the spacer unit (160).

5. The display device as claimed in claim 2, wherein the first sub-frame (141) has a third edge (1411a) and a fourth edge (1411b), and the first edge (1411d) is positioned between the third edge (1411a) and the fourth edge (1411b), and the width of the third edge (1411a) is smaller than the width of the fourth edge (1411b), wherein the distance between the spacer unit (160) and the third edge (1411a) is smaller than or equal to the distance between the spacer unit (160) and the fourth edge (1411b).

6. The display device as claimed in one of the preceding claims, wherein the display panel (130) further comprises a connecting unit (W) connecting the first edge (1411d) to the second edge (1421c), and the plurality of sub-frames (141, 142) is connected by the connecting unit (W) to form the frame (140).

7. The display device as claimed in claim 6, wherein the connecting unit (W) is a connecting structure formed by a method including welding, screwing, gluing, interlocking, clamping, or pressure fitting.

8. The display device as claimed in one of the preceding claims, wherein the spacer unit (160) comprises a first spacer structure (161) and a second spacer structure (162), and the first spacer structure (161) partially overlaps with the second spacer structure (162).

9. The display device as claimed in one of the preceding claims, further comprising a housing (129), wherein the display panel (130) is positioned between the frame (140) and the housing (129), and the frame (140) and the housing (129) are connected by a fastening portion.

10. The display device as claimed claim 1, further comprising a rear bezel (110) which comprises a bottom plate (111) and a plurality of side plates (113) perpendicular with the bottom place (111), wherein the at least one of the side plates (113) is engaged with the frame (140) to form a space to receive the display panel (140).
